# FASCICULE DE BREVET EUROPEEN

(11) **EP 0 420 739 B1**
(45) Date de publication et mention de la délivrance du brevet: **08.09.1993**
(21) Numéro de dépôt: 90402633.3
(22) Date de dépôt: 25.09.1990
(51) Int. Cl.: H01Q 25/00, H01Q 3/26, H01Q 3/40

(54) **Dispositif d'alimentation d'une antenne à faisceaux multiples**
Speiseeinrichtung für eine Mehrkeulenantenne
Feeding device for a multiple beam antenna

(30) Priorité: 26.09.1989 FR 8912584
(43) Date de publication de la demande: 03.04.1991
(73) Titulaire: AGENCE SPATIALE EUROPEENNE, F-75738 Paris Cedex 15 (FR)
(72) Inventeur: Roederer, Antoine, Noordwijk (NL)
(74) Mandataire: Rodhain, Claude

(56) Documents cités:
- EP-A- 0 333 166
- FR-A- 2 241 886
- GB-A- 2 209 629
- US-A- 3 740 756
- IEEE INTERNATIONAL CONFERENCE ON COMMUNICATIONS,1985 vol. 3, juin 1985, Chicago,Illinois,US; pages 1299 - 1303; S.V.PAREKH et al.: "Active Antennas For Satellite Communications"
- CONFERENCE PROCEEDINGS MILITARY MICROWAVES 86,juin 1986, Brighton,GB; pages 391A - 391F; L.G.CARDONE: "Wideband Electro-Optical Microwave Beamforming Technique"

## Description

L'invention concerne un dispositif destiné à l'alimentation d'antennes à faisceaux multiples, c'est à dire un dispositif qui permet de commander les amplitudes et les phases relatives des différents éléments rayonnants constituant les réseaux sources utilisés pour illuminer les dispositifs de focalisation de manière à constituer des antennes focalisatrices, les dispositifs de focalisation étant constitués par au moins un réflecteur ou une lentille (voir par exemple le EP-A-0 333 166, qui décrit une antenne focalisatrice de ce type).

Ces antennes focalisatrices sont en particulier utilisées dans le domaine des radiocommunications par satellite. Ces antennes peuvent fournir des pinceaux multiples conformés ou non conformés, fixes ou reconfigurables.

De telles antennes doivent présenter les qualités suivantes :
- gain maximal de couverture et valeur élevée du niveau de chevauchement des faisceaux,
- possibilité de déplacement des faisceaux et de reconfiguration par commande uniquement de la phase des signaux qui traversent les chaînes d'amplification,
- flexibilité complète de la puissance en radiofréquence pour l'allocation des faisceaux, jusqu'à la possibilité limite d'allouer toute la puissance à un seul faisceau,
- amplification répartie de la puissance en utilisant des amplificateurs identiques, chaque faisceau recevant des puissances égales de tous les amplificateurs, de manière à assurer une efficacité de bon fonctionnement et une dégradation tolérable en cas de défaillances,
- faibles lobes latéraux dans la couverture pour la réutilisation des fréquences ; faibles lobes latéraux à l'extérieur de la couverture,
- utilisation efficace du réflecteur pour assurer un espacement angulaire minimal entre les faisceaux ou les zones où l'on veut réutiliser les mêmes fréquences avec un découplage suffisant,
- possibilité de double polarisation dans certains faisceaux ou dans l'ensemble des faisceaux.

Pour obtenir ces différentes qualités, on a déjà proposé de nombreuses solutions. Dans les antennes réseau actives, chaque source participe à tous les faisceaux et une matrice de commutation de faisceaux travaillant à bas niveau, permet d'allouer un canal entier à un faisceau. Cependant, ces antennes réseau actives présentent les inconvénients suivants : pour obtenir des gains élevés, on est obligé de recourir à des déploiements complexes ; il est difficile de contrôler le niveau des lobes latéraux et des lobes de réseau en utilisant des amplificateurs identiques avec des amplitudes fixées ; enfin, il s'agit d'un système complexe et de poids élevé.

On a également proposé des antennes réseau actives agrandies par un ou plusieurs réflecteurs. Dans ce cas, le réseau d'alimentation est disposé de manière optimale entre le réflecteur et son foyer, ceci tendant à étaler la puissance de chaque faisceau sur la plus grande partie du réseau d'alimentation, avec une faible translation d'un faisceau à un autre. La commande des faisceaux est possible par commande uniquement en phase et on peut utiliser des amplificateurs identiques excités de manière uniforme comme dans une antenne réseau. Cependant, dans de tels systèmes à décalage par rapport au foyer, chaque faisceau n'utilise qu'une partie du réflecteur et du dispositif d'alimentation, ce qui entraîne l'utilisation de réflecteurs plus grands que pour les systèmes focalisés. De plus, la commande des lobes latéraux pour obtenir le chevauchement pose des problèmes lorsque l'on fait une commande par phase uniquement et que l'on utilise des amplificateurs identiques. Il se produit, de plus, un rayonnement erratique à l'extérieur de la couverture, ce qui entraîne une perte de balayage et la possibilité de problèmes d'interférence. Ce système ne peut fournir qu'un balayage limité contrairement aux réseaux normaux, et, enfin, on ne peut limiter l'utilisation de deux polarisations à un faisceau ou à seulement quelques faisceaux sans utiliser des connexions à toutes les sources élémentaires.

Les avantages de ce deuxième type d'antenne résident dans sa simplicité et on peut réduire certains de ces inconvénients en réalisant une conformation du réflecteur.

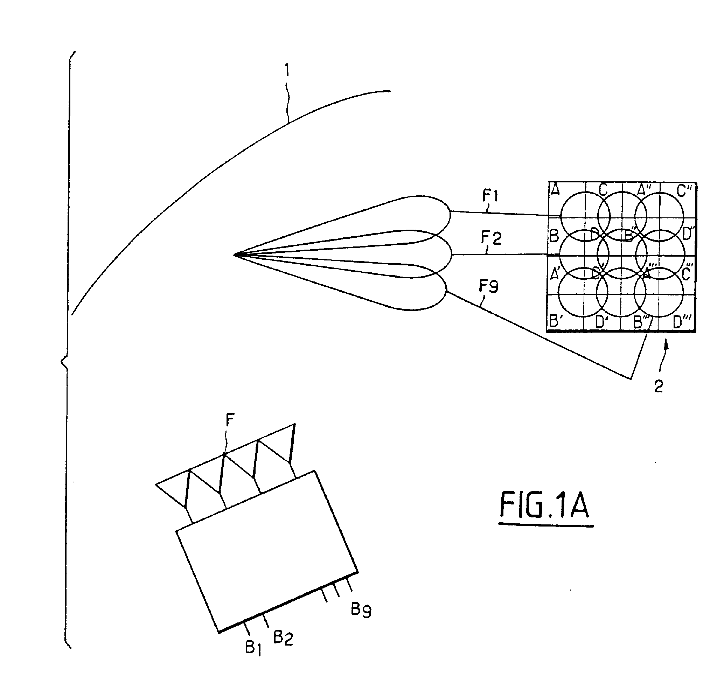

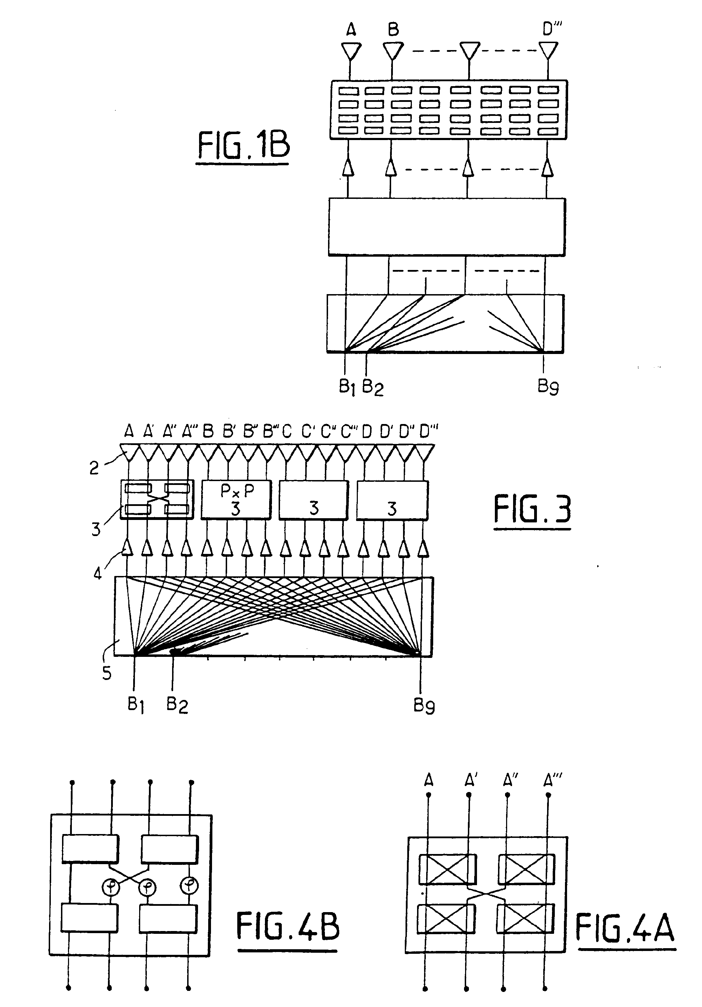

On a également proposé d'utiliser un réflecteur de focalisation avec un amplificateur classique à entrées et sorties multiples. Un tel dispositif est illustré sur les figures 1A et 1B.

Un réseau 2 de seize sources élémentaires A, B, C, D, A', B', C', D', A'', B'', C'', D'' et A''', B''', C''', et D''' est disposé dans le plan focal F d'un réflecteur paraboloïdal 1. Pour créer un faisceau tel que le faisceau n°1, repéré F1, on utilise quatre sources A, B, C et D qui sont excitées de manière égale. Ces sources peuvent être des cornets, des dipôles, des éléments imprimés sous forme de microbandes, ou d'autres types de radiateurs. Le faisceau n°2, repéré F2, qui est adjacent au faisceau n°1 utilise également quatre sources élémentaires B, D, A' et C', les sources B et D étant partagées avec le réseau n°1 ; le faisceau n°3 utilise les sources A', C', B' et D' et partage les sources A' et C' avec le faisceau n°2 et ainsi de suite. On utilise donc quatre sources alimentées de la même façon pour chaque faisceau et on peut augmenter la puissance allouée à un faisceau seulement en transférant plus de canaux à ces quatre faisceaux par une commutation à bas niveau à l'entrée de faisceau correspondante.

Le réflecteur est illuminé de manière efficace par quatre sources : les lobes latéraux sont faibles et le faible espacement des faisceaux qui est obtenu par un partage des sources a pour conséquence une chute minimale du gain à l'intersection des quatre zones de chevauchement de faisceaux.

Le problème est alors de répartir et d'amplifier la puissance provenant des entrées de faisceau B1 à B9 aux seize sources avec un minimum de pertes et en utilisant des amplificateurs de puissance identiques. En outre, il est souhaitable que chaque faisceau utilise tous les amplificateurs, chacun d'entre eux fonctionnant à la même puissance de sortie optimale, indépendamment de la puissance (nombre de canaux) allouée à ce faisceau à un instant donné.

Ce problème a été résolu de manière partielle, récemment, par l'utilisation de ce que l'on appelle un amplificateur à entrées et sorties multiples qui est alimenté par une matrice de formation de faisceaux à faibles pertes. Comme on peut le voir sur la figure 1B, les seize sources sont reliées à une matrice de circuits à micro-ondes comportant seize entrées et seize sorties et qui est constituée de telle manière que lorsque ses seize entrées sont alimentées par des signaux d'amplitudes égales et avec une loi de phase particulière, toute la puissance sortira par une sortie particulière. On utilise, de manière classique, ce que l'on appelle des matrices de Butler. Ces matrices sont telles que les lois de phase particulières mentionnées ci-dessus sont linéaires ou en gradins avec des niveaux qui sont des multiples de pi/16. Une telle matrice comprend quatre couches de diviseurs hybrides et sa matrice de diffusion (ou de transfert) est unitaire (sans perte) et orthogonale.

Cette matrice de 16 par 16 est alimentée par seize amplificateurs identiques reliés à une matrice identique 16 par 16 qui fonctionne à un niveau basse puissance. Dans cette configuration qui comporte deux matrices de Butler ou analogues dos à dos, une entrée de la matrice d'entrée correspond à une sortie (élément source) de la matrice de sortie. Dans ce cas, les faisceaux seront obtenus au moyen d'un diviseur à bas niveau qui comporte neuf entrées et seize sorties, chaque borne de faisceau étant reliée à quatre entrées de la matrice de Butler à bas niveau.

Ces dispositions permettent de répartir entre seize amplificateurs identiques la puissance pour chaque faisceau. Cependant, ce système présente les inconvénients suivants :
- du fait que ce n'est pas seulement une source (A) mais quatre sources (A, B, C, D) qui correspondent à chaque faisceau, il faut activer quatre entrées et non pas une seule pour exciter chaque faisceau (n°1). Pour cette raison, les signaux dans chaque amplificateur sont constitués par la superposition de quatre signaux provenant de quatre entrées différentes.

Ces signaux ont des amplitudes égales mais leurs phases relatives sont différentes dans les différents amplificateurs, et ceci a pour résultat qu'il existe, pour certains faisceaux, une ondulation d'amplitude parmi les seize amplificateurs qui ne fonctionnent donc pas tous à des niveaux identiques, avec une efficacité optimale. Il faut noter cependant que lorsqu'il y a plusieurs faisceaux fonctionnant à des fréquences différentes, l'ondulation générale décroît par effet de moyenne.
- De manière similaire, si l'on doit créer un faisceau global couvrant toute la zone, on alimente toutes les entrées de la première matrice de Butler et il en résulte une ondulation significative au niveau des amplificateurs.
- Les deux matrices, disposées dos à dos, utilisent chacune quatre couches de huit coupleurs hybrides et, par conséquent, chaque signal amplifié traverse quatre coupleurs, ce qui entraîne une perte et une sensibilité aux imprécisions des amplificateurs.
- Dans une matrice 2^{N} par 2^{N}, chaque signal traverse N coupleurs et le nombre total de coupleurs pour les deux matrices sera égal à Nx2^{N}, et la complexité qui en résulte limite le système à huit sources ou seize au plus.

Les amplificateurs à entrées et sorties multiples et les circuits hybrides à entrées et sorties multiples sont décrits en détail par exemple dans l'article de EGAMI et KAWAI dans IEEE JOURNAL ON SELECTED AREAS IN COMMUNICATIONS, Vol. SAC-5 n°4, Mai 1987, pages 630 à 636.

On a également proposé d'autres solutions ; par exemple, on a proposé d'utiliser des lentilles à la place de l'amplificateur à entrées et sorties multiples, mais ces dispositifs ont des pertes plus élevées et leur poids est également plus élevé. Ces derniers dispositifs pourraient mieux être adaptés cependant pour la création d'un nombre élevé de faisceaux à des fréquences plus élevées, car dans ce cas, les systèmes à matrice sont trop complexes et ont des pertes trop élevées.

Par ailleurs, le US-A-4 901 085, au nom Spring et al., déposé le 23 septembre 1988 mais publié le 13 février 1990, décrit une configuration pour un système d'alimentation d'antenne à faisceaux multiples comprenant une pluralité d'amplificateurs de puissance à matrice hybride ou HMPAs (Hybrid Matrix Power Amplifier) de petite taille, de préférence tous identiques.

Chacun de ces HMPAs, qui comporte une matrice d'entrée et une matrice de sortie interconnectées par des amplificateurs de puissance, est monté entre, d'une part, un réseau de formation de faisceaux à bas niveau et, d'autre part, les éléments rayonnants.

Cette configuration comporte un ensemble d'amplificateurs placés entre des matrices d'entrée et de sortie présentant entre elles une symétrie en miroir. Une telle structure, qui implique un dédoublement des matrices, est de ce fait relativement complexe, encombrante et lourde (caractéristiques importantes dans le cas d'une antenne embarquée sur satellite). En second lieu, dans la configuration décrite par ce brevet, le réseau formateur de faisceaux relie chaque port de sélection de faisceau à certains ports d'entrée des HMPAs. Dès lors, les divers amplificateurs ne sont pas toujours chargés identiquement, amenant dont à une perte d'efficacité du système, comme cela ressort des tableaux 1, 2 et 3 de la description de ce brevet.

Enfin, le système décrit par cette antériorité ne permet pas de variation du pointage du faisceau tout en conservant une charge uniforme sur les amplificateurs, alors qu'il s'agit là d'une caractéristique hautement souhaitable pour les antennes de radiocommunication par satellite.

La présente invention concerne une antenne à faisceaux multiples qui permette de pallier tous ces inconvénients et d'obtenir l'ensemble des qualités qui ont été citées plus haut.

Cette antenne, qui comprend les éléments visés par le préambule de la revendication 1, est caractérisée par un dispositif d'alimentation selon la partie caractérisante de cette revendication.

Un certain nombre de caractéristiques avantageuses sont énoncées dans les sous-revendications.

D'autres avantages et caractéristiques de l'invention ressortiront de la description qui suit, faite à titre illustratif et nullement limitatif en se référant aux dessins ci-annexés, étant précisé que les références numériques identiques désignent d'un dessin à l'autre des éléments fonctionnellement semblables, dessins sur lesquels :
- les figures 1A et 1B décrivent un dispositif d'alimentation de type connu comportant un réflecteur de focalisation associé à un amplificateur classique à entrées et sorties multiples.
- les figures 2 à 4A et 4B illustrent un dispositif d'alimentation d'antenne réseau selon l'invention,
- les figures 5, 6A et 6B, 7A et 7B, 8A et 8B, 9A à 9C, 10A et 10B, 11A et 11B, 12A et 12B, 13A et 13B, 14A et 14B, 15A et 15B, 16A et 16B, 17A et 17B, 18A et 18B, et 19A et 19B représentent d'autres modes de réalisation de l'invention pour des valeurs différentes du nombre de sources et/ou du nombre de diviseurs de puissance,
- la figure 20 illustre une répartition des faisceaux et une couverture typique pour une antenne à réflecteur travaillant à 1,6 GHz et couvrant l'Europe,
- les figures 21A et 21B représentent la configuration du réflecteur et des sources de l'exemple de réalisation des faisceaux de la figure 20,
- la figure 22 représente un réseau d'alimentation pour obtenir les faisceaux en traits pleins de la figure 20 (Europe seulement),
- la figure 23 représente un système d'alimentation pour obtenir tous les faisceaux de la figure 20 (couverture élargie),
- les figures 24A à 24C sont des figures explicatives permettant de comparer l'invention à un système d'alimentation classique.
- les figures 25A et 25B, 26A et 26B, 27A et 27B, 28A et 28B et 29A et 29B illustrent encore d'autres modes de réalisation de l'invention.

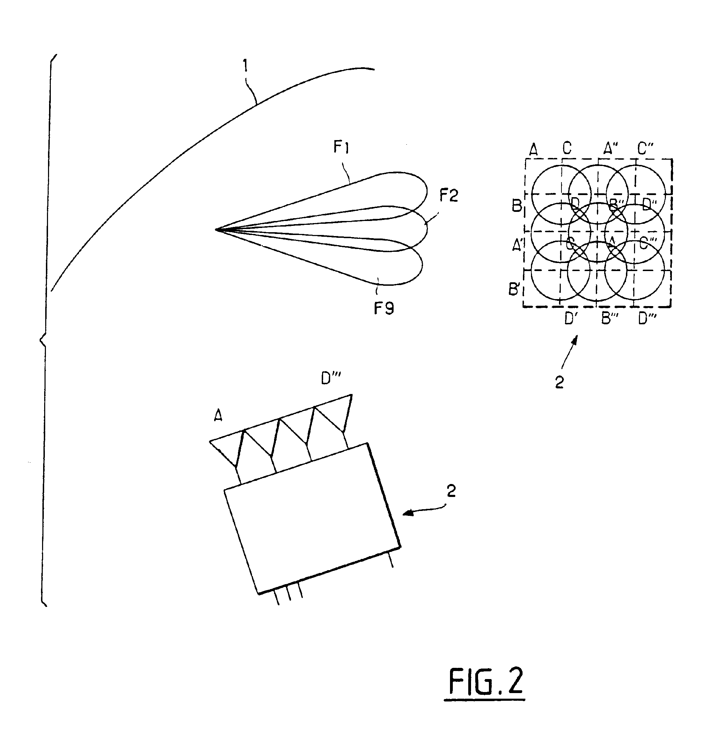

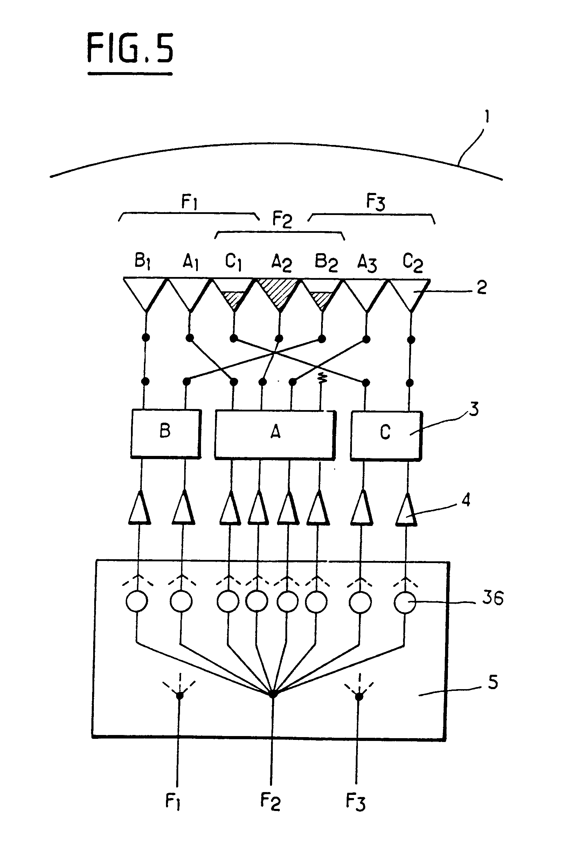

Les figures 2 à 4A et 4B illustrent le principe de l'invention dans le cas correspondant à celui des figures 1A et 1B.

Dans cet exemple, 1 désigne un dispositif optique de focalisation, généralement un réflecteur paraboloïde qui est alimenté par un dispositif d'alimentation 2 comprenant Ne (16 dans l'exemple représenté) sources A, A', A'', A''', B, B', B'', B''', C, C', C'', C'', D, D', D'', D''' disposé au foyer F du réflecteur 1 de telle manière que chaque faisceau est engendré par Nc (4 dans l'exemple représenté) sources, des faisceaux adjacents ayant au moins une source en commun (2 dans l'exemple représenté).

Conformément à l'invention, le dispositif d'alimentation représenté à la figure 3 comprend un nombre égal à Nc (4 dans l'exemple) de diviseurs 3 à matrice orthogonale et unitaire. Ces matrices sont carrées et leur ordre P est égal à la puissance de 2 égale ou immédiatement supérieure au rapport Ne/Nc ; dans l'exemple représenté, Ne = 16, Nc = 4, et P = 4.

Ces diviseurs 3 à matrice orthogonale comportant P entrées et P sorties sont tels que lorsque l'une de leurs entrées est excitée, toutes leurs sorties fournissent des puissances égales sans pertes autres que les pertes ohmiques, ce qui justifie le nom de matrice unitaire. Lorsqu'on excite une autre entrée isolément, les phases des signaux sur les sorties sont telles que les produits scalaires complexes des vecteurs de sortie sont tous égaux à zéro ; il s'agit donc de matrices orthogonales.

La figure 4A représente un tel diviseur à matrice unitaire et orthogonale quatre par quatre de type connu. Chaque entrée est reliée à un coupleur hybride à 3 dB qui comprend quatre bornes et qui divise le signal d'entrée par deux. Les deux signaux obtenus sont envoyés vers deux coupleurs hybrides différents à 3 dB et quatre bornes qui réalisent une deuxième division par deux et un déphasage des signaux vers la sortie où chaque coupleur de sortie est branché à deux sources. Des exemples typiques de ces diviseurs à matrice sont utilisés dans des amplificateurs classiques de type multiport et sont décrits dans l'article de EGAMI et KAWAI cité plus haut. On peut évidemment utiliser d'autres arrangements, par exemple avec des déphaseurs et des coupleurs identiques ou non, comme illustré à la figure 4B ; le point important est que le diviseur à matrice fournisse de la puissance à un élément source spécifique dans chaque groupe de sources engendrant un faisceau, l'élément A pour la matrice A, l'élément B pour la matrice B, etc.

Les diviseurs à matrice sont alimentés par un ensemble d'amplificateurs 4 identiques de type classique, au nombre de seize dans l'exemple représenté. La puissance de sortie de chacun de ces amplificateurs 4 est répartie par les diviseurs à matrice sur les éléments sources de tous les faisceaux.

Les amplificateurs de puissance sont alimentés par un réseau formateur de faisceaux 5 qui présente un nombre d'entrées égal au nombre de faisceaux désiré, neuf dans l'exemple représenté. Ce réseau formateur 5 est à faible niveau et peut donc présenter des pertes ; il peut fonctionner soit à la même fréquence que les amplificateurs soit à une fréquence intermédiaire inférieure, auquel cas on doit prévoir un convertisseur de fréquence en amont de chaque amplificateur de puissance.

La figure 5 illustre une variante de réalisation dans laquelle les diviseurs de puissance à matrice 3 ne sont pas tous d'ordres identiques.

Dans cette configuration de la figure 5, trois sources A, B et C contribuent à un faisceau mais, contrairement aux exemples précédents, toutes les sources ne reçoivent pas la même puissance. Ainsi, dans cet exemple de la figure 5, les sources A reçoivent typiquement deux fois plus de puissance que chaque source B ou C, ce qui est symbolisé par la surface hachurée différente des triangles symbolisant les sources 2, l'étendue du hachurage étant proportionnelle à la puissance reçue.

La configuration illustrée permet d'obtenir trois faisceaux elliptiques F1, F2 et F3. Les diviseurs B et C sont des matrices 2x2, tandis que le diviseur A est une matrice 4x4, dont l'une des sorties non utilisée est terminée sur une charge.

Bien entendu, d'autres dispositifs avec des diviseurs d'ordres 2, 3, 4, 6, 8, etc. en nombre différent sont concevables, en fonction de la forme et de la répartition de puissance des différents faisceaux que l'on souhaite obtenir.

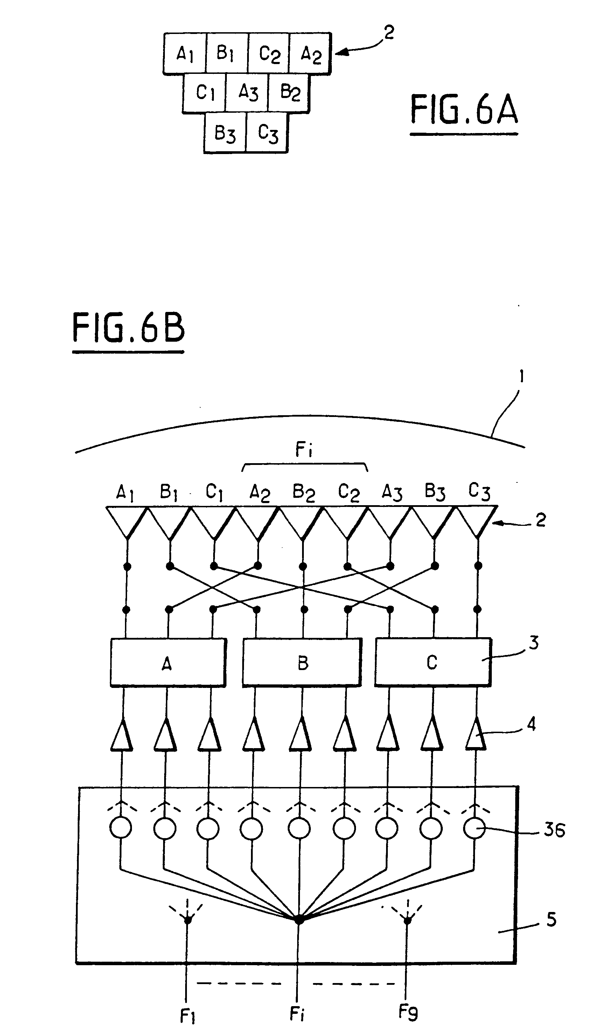

Les figures 6A et 6B illustrent un cas particulier d'un mode de réalisation dans lequel on choisit pour les diviseurs de puissance des composants ayant pour ordres des puissances de 3 ou des multiples communs de puissances de 2 et de 3 (c'est-à-dire 2, 3, 4, 6, 8, 9, 12, 16, 18, etc.).

Ainsi, dans cet exemple, trois sources adjacentes A, B, C (comme illustré figure 6A) contribuent au faisceau.

Ces trois sources reçoivent typiquement des puissances égales, délivrées par des diviseurs de puissance d'ordre 3 comme illustré figure 6B.

Ces diviseurs de puissance 3 sont par exemple du type décrit dans un article de J.P. SHELTON et K.S. KELLEHER intitulé "Multiple Beams from Linear Arrays", paru dans les IRE TRANSACTIONS ON ANTENNAS AND PROPAGATION - mars 1961, pages 154 à 161.

Dans cet exemple, sept faisceaux F1... Fi... F9 sont disponibles, mais bien entendu d'autres dispositifs à diviseurs d'ordre 6, 9, 12, 18, etc., constitués à partir de diviseurs élémentaires d'ordre 2 et 3, sont concevables.

Par ailleurs, dans ce mode de réalisation comme dans les autres, il peut être avantageux d'ajuster les phases des signaux en sortie du réseau formateur de faisceaux 5 au moyen de déphaseurs 36, fixes ou variables, afin d'optimiser la position et/ou la forme des lobes secondaires de chaque faisceau.

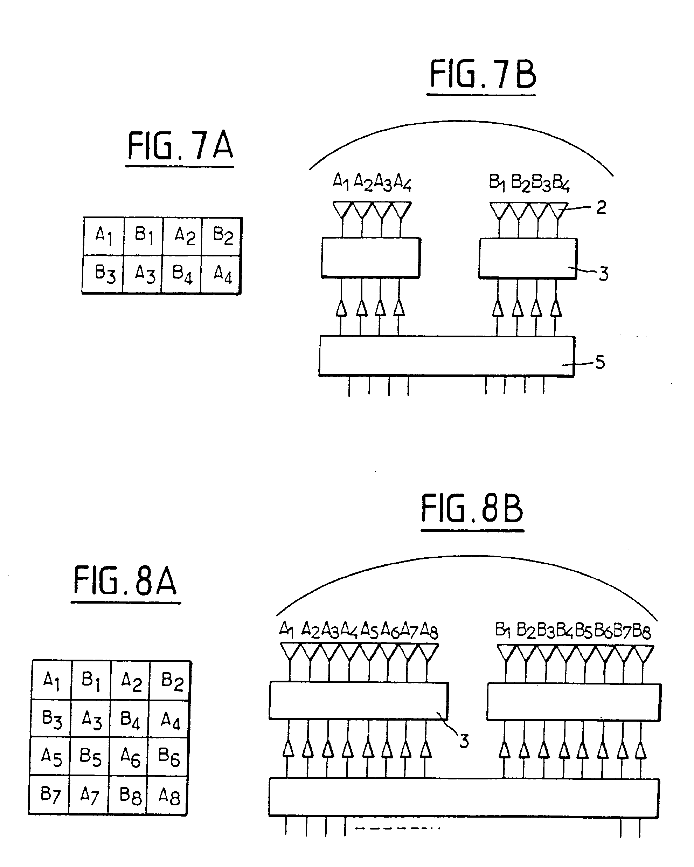

Les figures 7 à 19 représentent d'autres modes de réalisation de l'invention dans lesquels les divers paramètres Ne, Nc et Nb sont différents.

Dans le cas des figures 7A et 7B, le nombre de sources Ne est égal à huit et le nombre Nc de sources par faisceaux est égal à deux ; dans ce cas, l'ordre P des matrices A est égal à quatre.

Dans le cas des figures 8A et 8B, le nombre des sources Ne est égal à seize et le nombre Nc de sources par faisceau est égal à deux ; dans ce cas l'ordre P des matrices 3 est égal à huit, c'est à dire deux à la puissance trois.

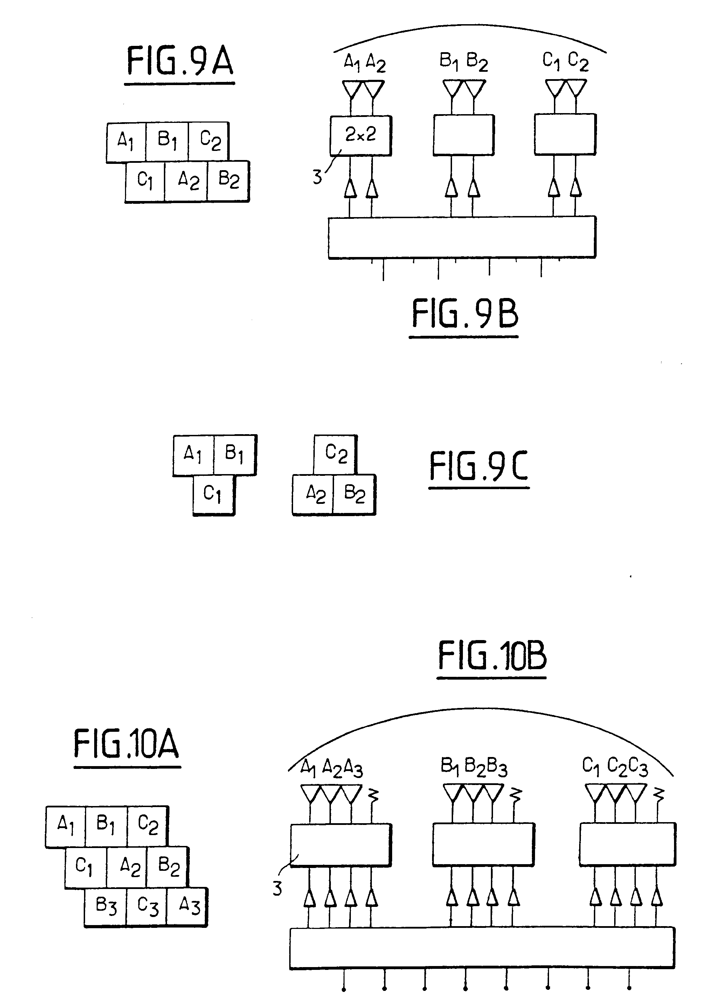

Dans le cas des figures 9A à 9C, le nombre des sources Ne est égal à six et le nombre Nc de sources par faisceau est égal à trois ; par conséquent, les matrices 3 sont d'ordre 2.

Dans le cas des figures 10A et 10B, le nombre des sources est égal à neuf et le nombre de sources par faisceau à trois ; l'ordre P des matrices 3 est donc égal à quatre, c'est-à-dire la puissance de deux immédiatement supérieure au rapport 9/3. On pourrait aussi utiliser trois matrices d'ordre 3.

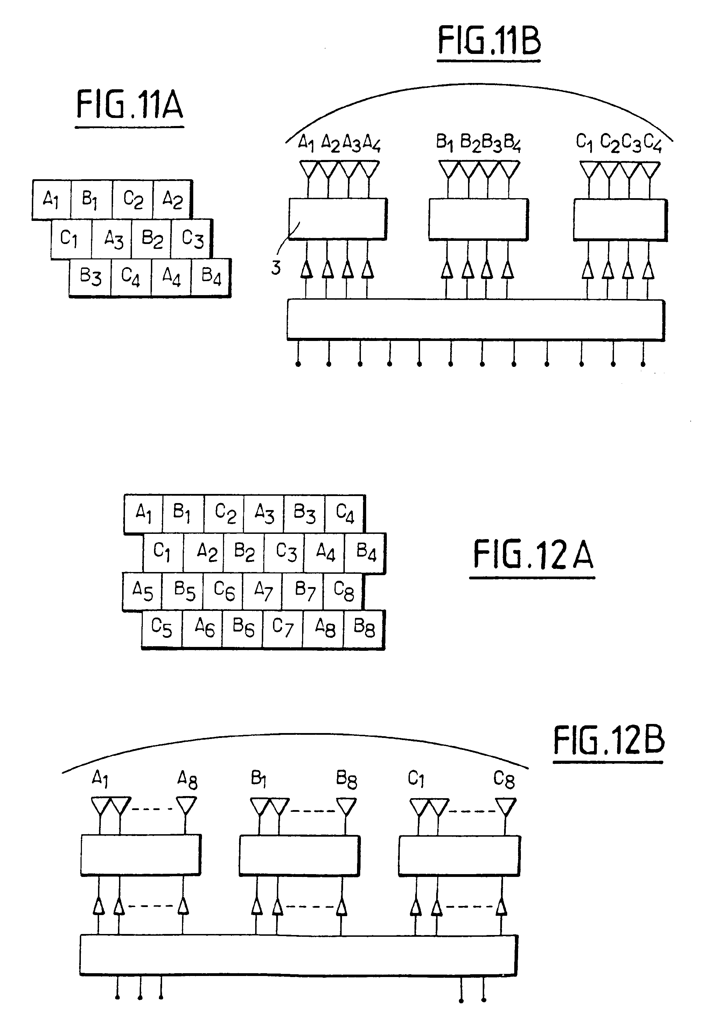

Dans le cas des figures 11A et 11B, le nombre de sources est égal à douze et le nombre de sources par faisceau est toujours égal à trois ; l'ordre P est donc égal à quatre c'est à dire le rapport 12/3.

Dans le cas des figures 12A et 12B, le nombre de sources par faisceau est toujours trois, mais le nombre de sources est égal à vingt quatre ; l'ordre P des matrices 3 est alors huit qui est égal au rapport 24/3.

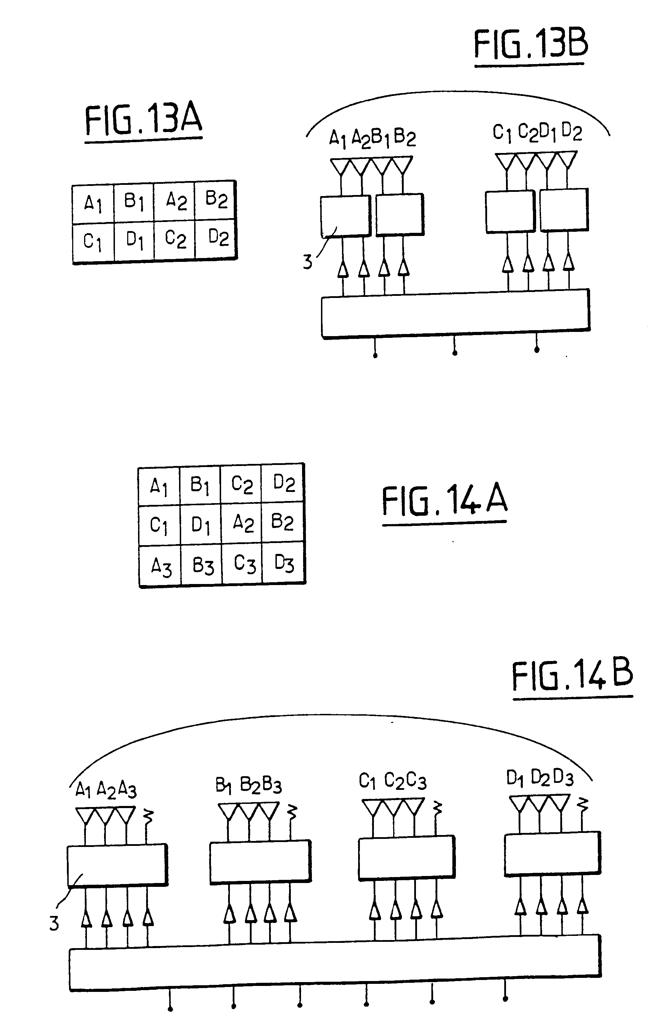

Les figures 13 à 15 représentent les configurations dans lesquelles on utilise quatre sources pour former chaque faisceau ; dans le cas des figures 13A et 13B, Ne = 8, Nc = 4 et les matrices 3 sont donc d'ordre 2.

Dans le cas des figures 14A et 14B, Ne = 12, le rapport Ne/Nc est égal à trois, et par suite, l'ordre P des matrices 3 est égal à quatre.

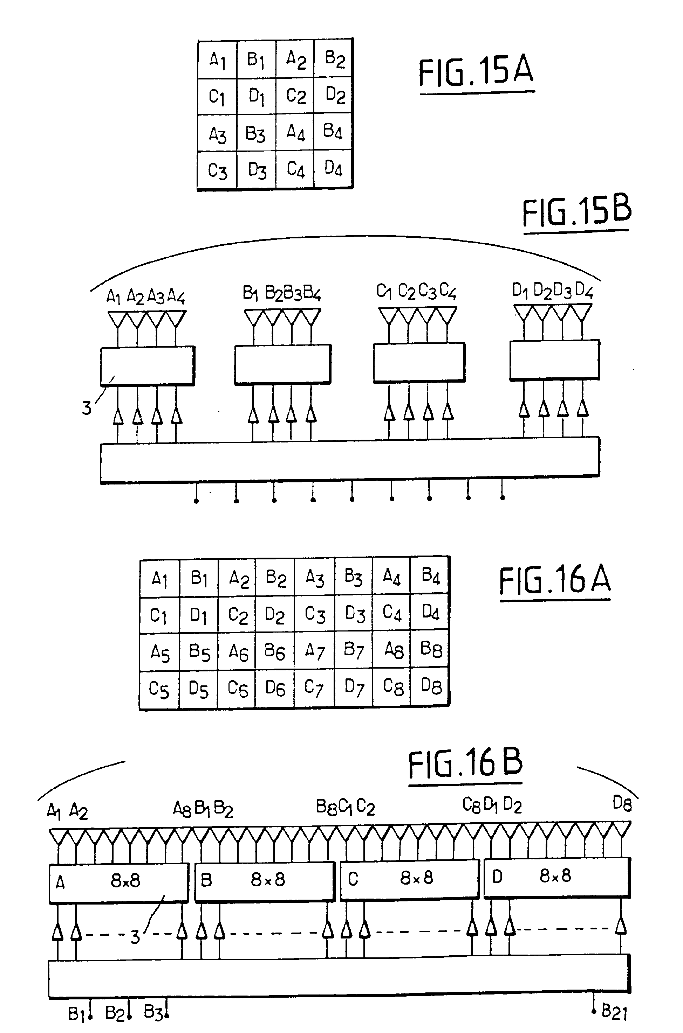

Enfin, dans le cas des figures 15A et 15B, on utilise seize sources et le rapport Ne/Nc est donc égal à quatre qui est donc aussi la valeur de l'ordre des matrices 3.

Dans le cas des figures 16A et 16B, le nombre des sources est égal à trente-deux et le nombre de sources par faisceau est égal à quatre ; par conséquent, l'ordre P est égal à deux à la puissance trois c'est à dire à huit.

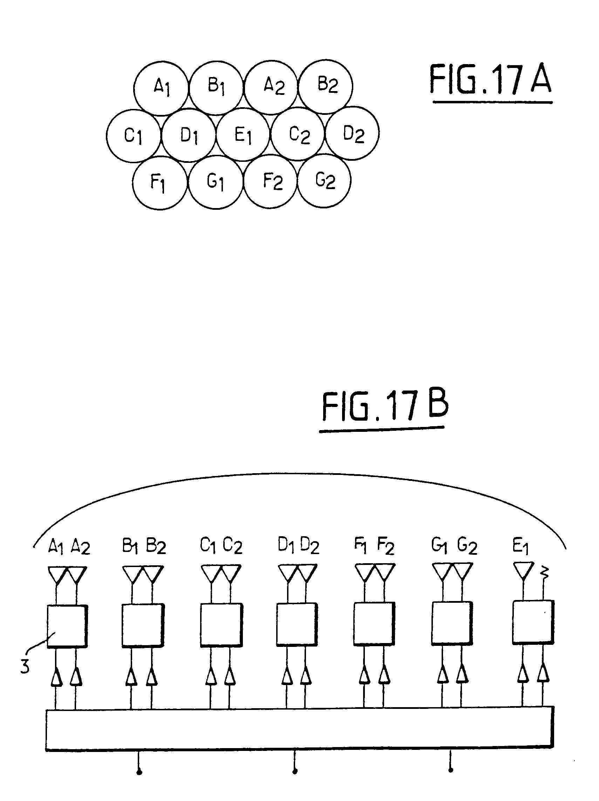

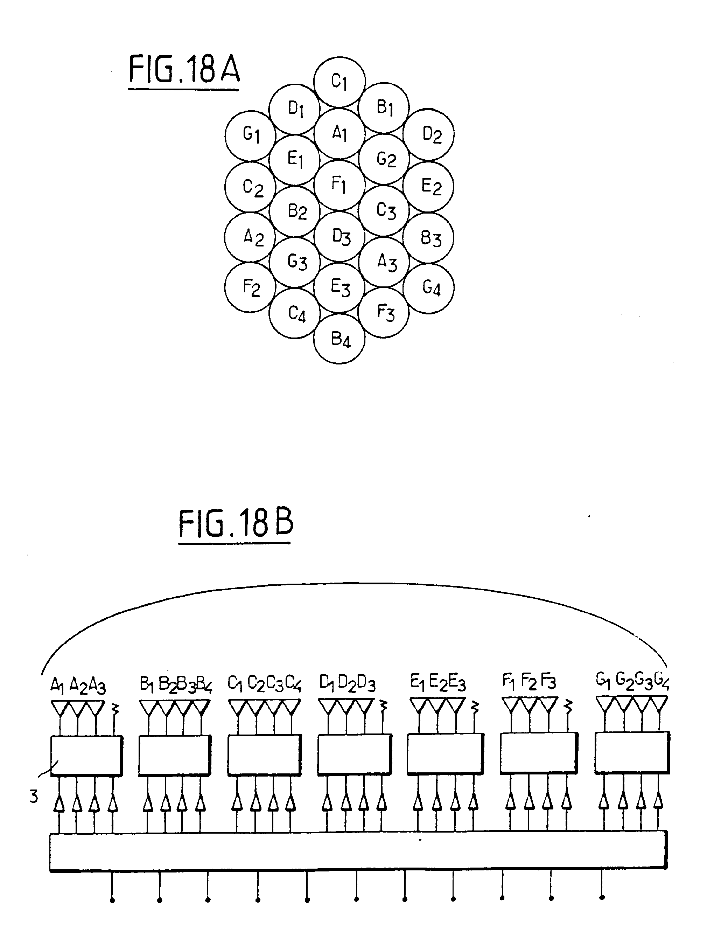

Dans le cas des figures 17 et 18, on utilise sept sources pour former chaque faisceau. Dans le cas des figures 17A et 17B, le nombre des sources est égal à treize et par conséquent l'ordre P est égal à deux qui est tout juste supérieur au rapport 13/7.

Dans le cas des figures 18A et 18B, Ne est égal à vingt-quatre, le rapport Ne/Nc est égal à 27/7 et l'ordre P est égal à quatre.

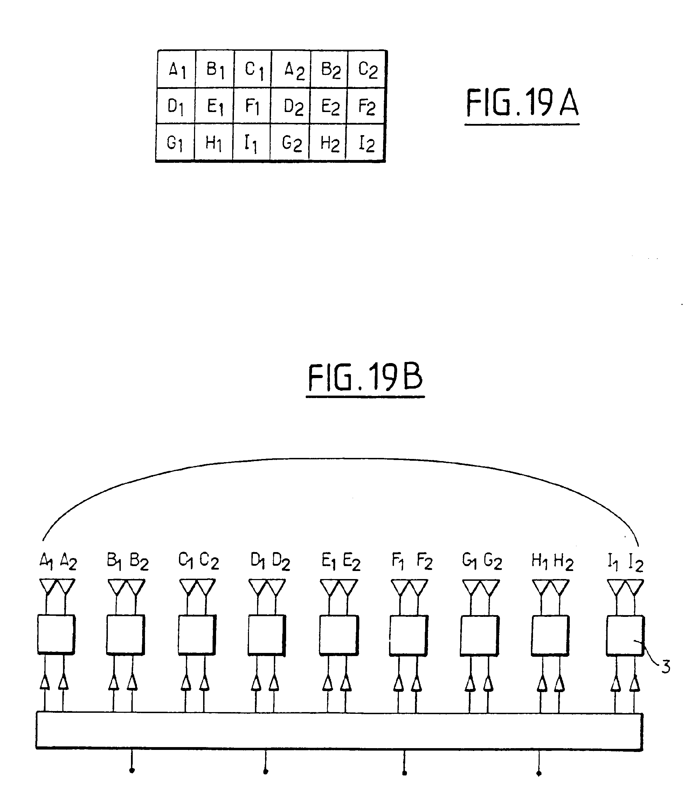

Les figures 19A et 19B représentent un dernier mode de configuration dans lequel on utilise neuf sources pour former chaque faisceau ; le nombre des sources est égal à dix-huit ; par conséquent l'ordre P des matrices 3 est égal à deux.

Parmi tous les exemples de configuration qui viennent d'être décrits, on pourra noter que dans certains cas, à savoir les configurations des figures 10, 14 et 17, l'une des bornes de sortie de certains des diviseurs à matrice 3 est en l'air, c'est à dire qu'elle n'est pas reliée à une source mais à une charge. On verra cependant que, même dans ce cas, l'invention permet de réaliser une configuration comportant moins d'éléments que les configurations de type connu.

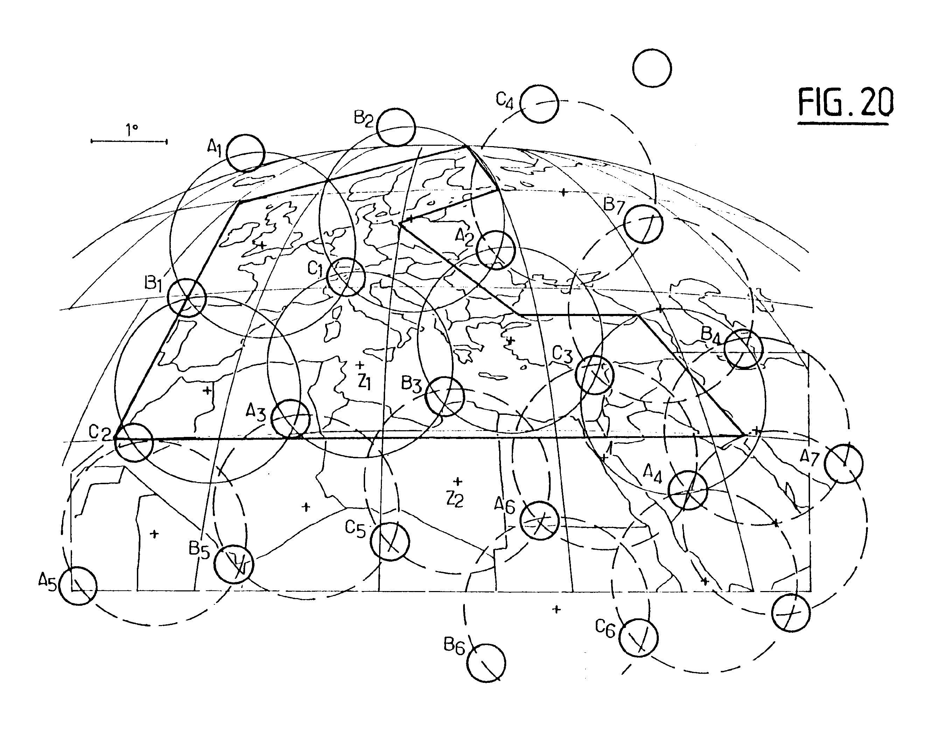

La figure 20 illustre un exemple d'application d'une antenne réseau alimentée conformément à la présente invention, il s'agit d'une configuration de faisceaux et d'une couverture destinée à couvrir l'Europe et travaillant avec une antenne à réflecteur conforme à la présente invention et travaillant à la radiofréquence de 1,6 GHz. Dans cette disposition, la zone Z1 est couverte par six faisceaux, et la zone Z2 par huit faisceaux. Deux ou plusieurs positions supplémentaires de faisceau sont disponibles pour réaliser une reconfiguration ; on dispose au total de vingt-six positions de faisceau pour des faisceaux de balayage avec un changement de multiplicité "cross over" élevé.

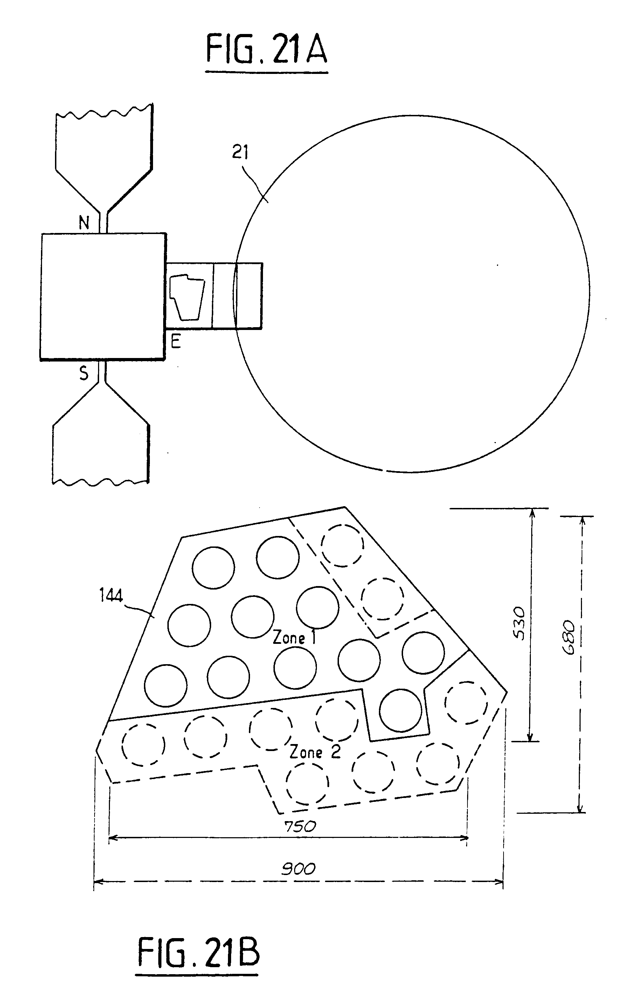

Comme on peut le voir sur la figure 21A, on utilise un réflecteur dont on a représenté le fond 21 dont le diamètre est de 5500 mm, la distance focale de 3 125 mm, l'espacement étant de 750 mm. Le réflecteur 21 présente une pondération d'illumination sur les bords de -10 à -12 dB. Les références d'orientation N, S et E désignent respectivement le Nord, le Sud et l'Est.

La largeur de faisceau pour la demi-puissance est de 2,3° et la directivité de pointe est de 37,0 dB. Le niveau de recoupement entre les faisceaux fixés est de 3,0 dB (directivité 34,0 dB), les faisceaux fixes adjacents présentent une source en commun. Le niveau de recoupement entre les faisceaux pouvant être balayés (et, si possible avec d'autres faisceaux fixes additionnels) est de -1 dB (directivité 36,0 dB).

Le niveau de lobe latéral est de l'ordre de 25 dB. On peut réaliser une reconfiguration par transfert de puissance à des faisceaux avec des empreintes ("footprint") sur la zone de couverture. On peut prévoir des faisceaux à polarisation orthogonale, par exemple dans les zones à trafic élevé.

Comme on peut le voir sur la figure 21B, la distance entre les centres de deux sources adjacentes est de 144 mm. De manière classique, la droite normale au réseau d'alimentation est dirigée vers le centre du réflecteur. Des solutions dans lesquelles le réseau d'alimentation se trouve le long de la paroi du véhicule porteur sont possibles mais avec une dégradation des performances et une complexité accrues. Pour la zone Z1 on utilise des éléments d'alimentation représentés en trait plein ; les éléments d'alimentation utilisés par la zone Z2 et pour la reconfiguration dans des zones étendues (vers l'Est dans le cas présent) sont représentés en trait interrompu.

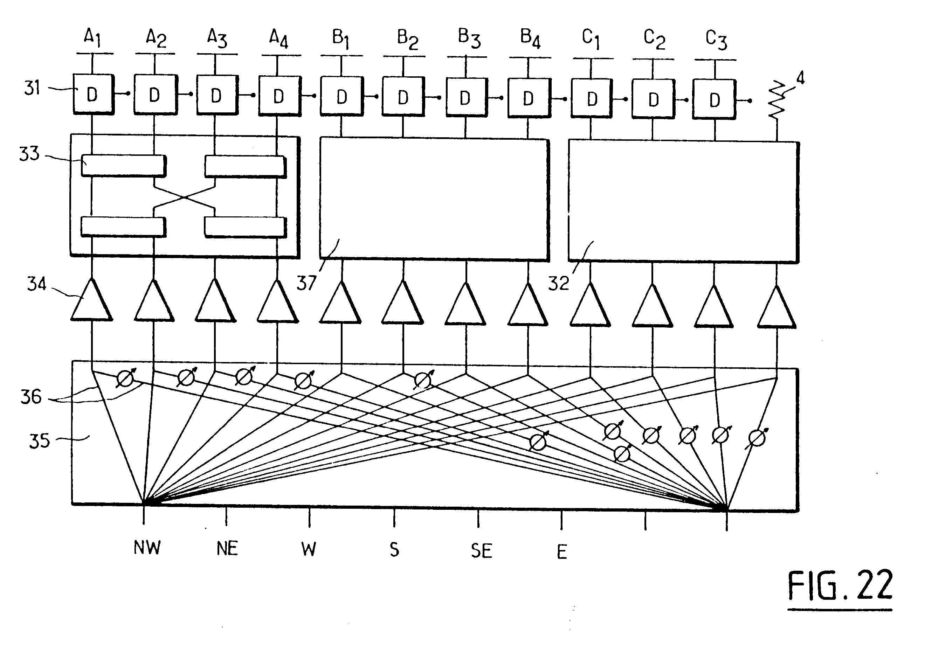

La figure 22 représente une configuration à 11 éléments sources avec un faisceau ajustable. Dans cette configuration, chaque faisceau utilise une source A, une source B et une source C. Les duplexeurs 31 disposés sur les bornes de réception sont reliés à des amplificateurs à faible bruit qui sont eux-mêmes connectés sur un formateur de faisceau fonctionnant en radiofréquence ou en fréquence intermédiaire (FI) et non représentés sur la figure.

Il est également possible d'utiliser des éléments à "auto-duplexage" au prix de quelques modifications sans changer le principe de base. Les trois matrices hybrides multiport à faibles pertes 32 comportent chacune quatre coupleurs hybrides 33 réalisés de manière classique, selon la technologie à ligne TEM (champs magnétique et électrique transverses). La borne n°4 inutilisée de la matrice reliée aux sources C est fermée ("terminated") et du fait qu'elle n'est pas excitée, il n'y a pas de perte de puissance. Chaque faisceau utilise l'ensemble des douze amplificateurs 34 identiques, si possible avec redondance. La panne d'un amplificateur crée une perte de 0,4 dB en puissance et, dans une faible partie de la couverture de chaque faisceau, une perte en gain qui n'excède pas 1,0 dB dans le pire des cas. Cela dégrade également l'isolement entre faisceaux avec une valeur pouvant aller jusqu'à 16 dB dans une partie du faisceau.

On peut prévoir un surdimensionnement ou une redondance des amplificateurs afin de compenser de tels défauts. Contrairement à ce qui se passe dans un groupe d'alimentations à recouvrement comportant des amplificateurs multiport de type classique, il n'y a pas d'ondulation dans l'amplificateur (à l'entrée) et donc sur les sorties destinées à engendrer les faisceaux. Tous les amplificateurs peuvent être utilisés avec leur rendement maximal. Le réseau formateur de faisceaux 35 à bas niveau peut fonctionner à la radiofréquence en utilisant par exemple des lignes sous forme de bandes imprimées de faible largeur ("microstrip"), ce qui est possible avec des composants de type "MMIC".

Pour les faisceaux fixes, on utilise des déphaseurs fixes sur les lignes d'alimentation. Des déphaseurs variables 36 à 2 bits permettent d'engendrer des faisceaux commandables se recoupant les uns les autres au niveau de -1 dB (directivité 36,0 dB). Un faisceau global utilisant l'ensemble des onze sources peut être créé ; cela ne créera pas d'ondulation au niveau des amplificateurs si l'on utilise des circuits hybrides multiports.

Les deux dernières entrées du réseau formateur sont utilisées l'une pour le faisceau global, et l'autre pour le faisceau pouvant être ajusté.

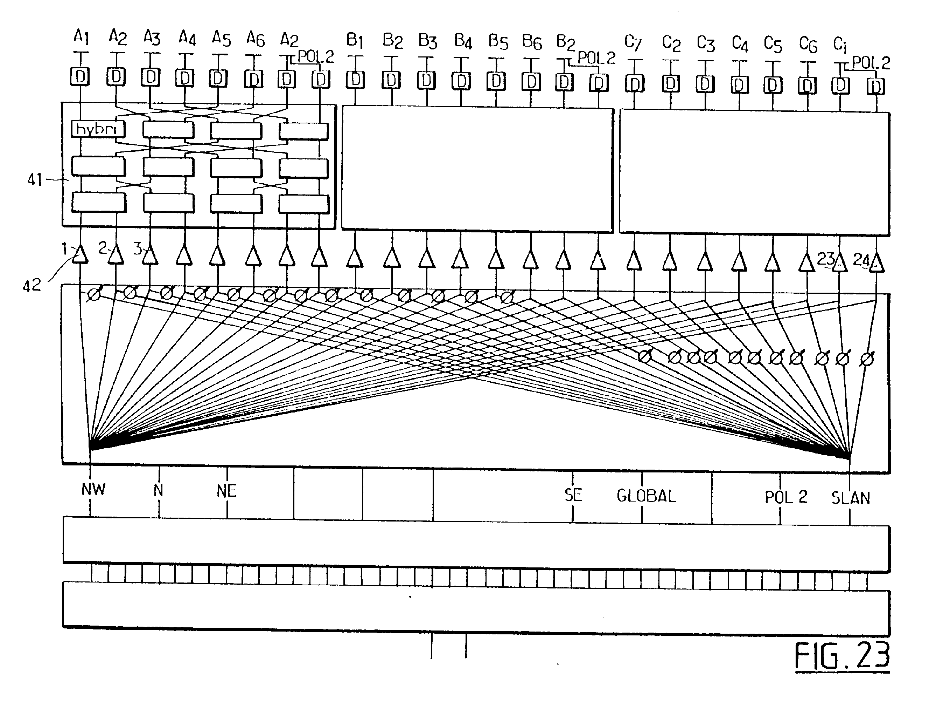

La figure 23 représente une configuration d'alimentation pour une antenne réseau fonctionnant à 1,6 GHz sur une couverture élargie. Dans cette configuration, on utilise vingt-et-une sources dont trois sont excitables selon deux polarisations. Les trois matrices hybrides multiports à faibles pertes 41 comprennent chacune douze coupleurs hybrides. Toutes les sorties sont utilisées et trois d'entre elles sont utilisées pour fournir un faisceau à polarisation orthogonale.

Dans ce cas encore, chaque faisceau utilise l'ensemble des vingt-quatre amplificateurs de puissance identiques 42. La panne d'un amplificateur entraîne une perte de 0,2 dB en puissance et une perte locale en gain dans chacun des faisceaux n'excédant pas 0,5 dB dans le pire des cas. La panne d'un amplificateur entraîne une dégradation de l'isolement des faisceaux qui peut aller jusqu'à 22 dB dans une partie du faisceau. Il est possible de maintenir les effets des tolérances d'isolation concernant les composants du diviseur à matrice en dessous de -35 dB dans un fonctionnement à bande étroite. Les effets des erreurs d'amplitude et de phase des signaux d'entrées sont acceptables, comme cela est indiqué dans l'article cité plus haut de EGAMI et KAWAI.

On obtient une reconfiguration en déphasant des canaux au niveau des entrées de faisceaux avec des empreintes ("footprint") correspondantes qui couvrent la zone désirée. Une commande du faisceau au moyen de déphaseurs à deux bits seulement fournit un niveau de recoupement qui est au plus égal à 1 dB entre des positions discrètes de faisceaux.

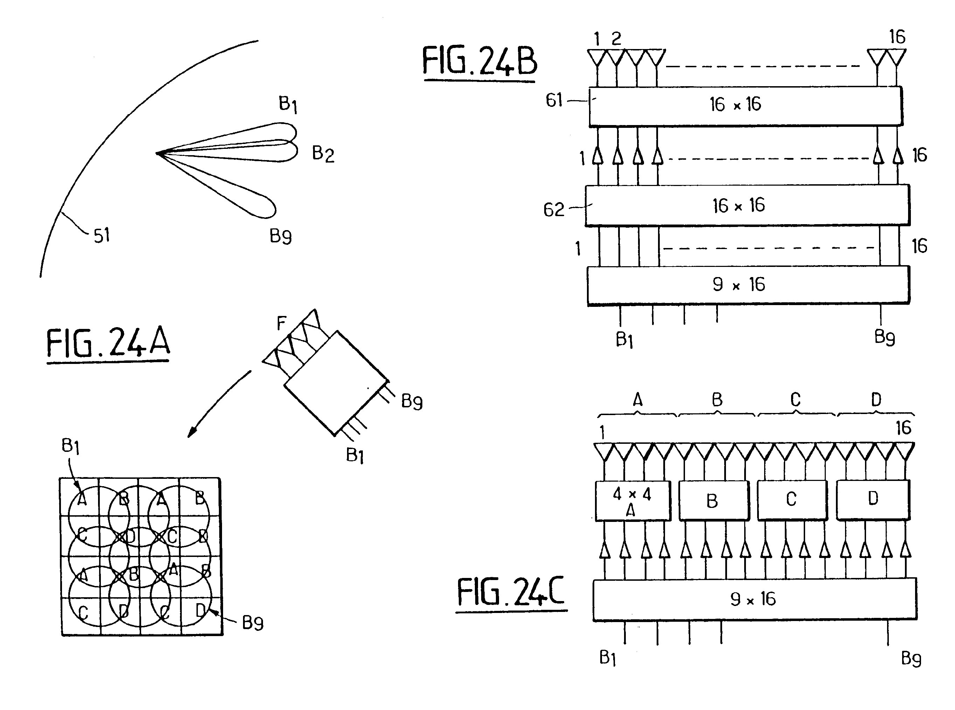

Les figures 24A à 24C illustrent les avantages de l'invention par rapport à une solution à amplificateurs multiports classiques. Le système de la figure 24A comporte une optique de focalisation 51, par exemple une portion de paraboloïde, qui est utilisée avec un réseau 4 x 4 d'alimentation. Dans la solution classique selon la figure 24B, on utilise un nombre total de coupleurs égal à 64, la longueur totale de lignes à pertes est d'environ seize fois la longueur d'onde pour la puissance la plus élevée et on obtient une ondulation notable au niveau des amplificateurs du fait du partage des sources.

Dans le dispositif classique de la figure 24B, un répartiteur 61, 62 est du type 16 x 16 et utilise 32 coupleurs.

Par contre, dans la solution conforme à la présente invention représentée sur la figure 24C, on n'utilise, toujours pour la même configuration, qu'un nombre total de coupleurs égal à seize, la longueur totale de lignes à pertes étant approximativement égale à quatre longueurs d'onde ; il n'y a pas d'ondulation au niveau des amplificateurs et, enfin, chaque faisceau utilise tous les amplificateurs uniformément chargés et une source de chaque groupe.

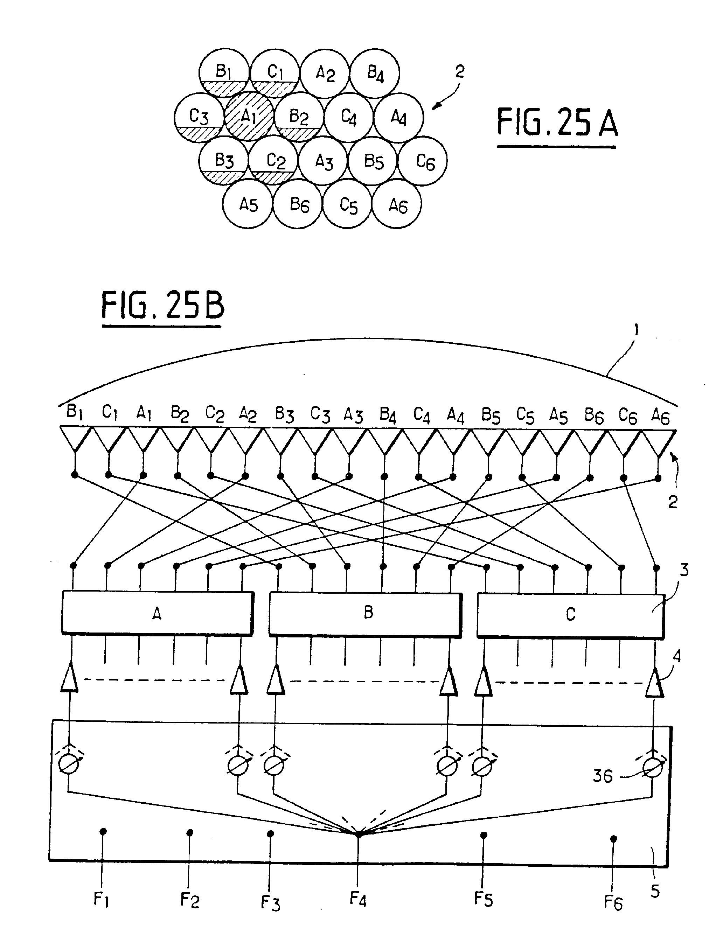

On va maintenant décrire, en référence aux figures 25 à 29, des modes de réalisation dans lesquels, pour améliorer le rendement et/ou la forme et/ou les lobes secondaires du faisceau, on relie une pluralité de sources 2 à un même diviseur de puissance 3.

Ainsi, dans le cas des figures 25A et 25B sept sources adjacentes contribuent à chaque faisceau, la source centrale recevant trois fois plus de puissance que chacune des six autres, ce qui permet notamment d'améliorer le rendement (débordement ou "spillover" réduit) et les lobes secondaires de chaque faisceau.

Dans cet exemple, six faisceaux sont disponibles, et l'on utilise à cet effet trois diviseurs de puissance en forme de coupleur 6x6. Parmi les sept sources utilisées pour chaque faisceau, trois sont reliées à l'un des diviseurs, trois sont reliées à un autre diviseur et une est reliée au troisième diviseur, ce qui permet d'obtenir la répartition de puissance voulue (répartition de puissance symbolisée sur la figure 25A par les surfaces hachurées d'étendue différente.

On notera que l'on peut en outre prévoir des déphaseurs 36, fixes ou variables, pour orienter la puissance sur une ou trois sorties d'un diviseur.

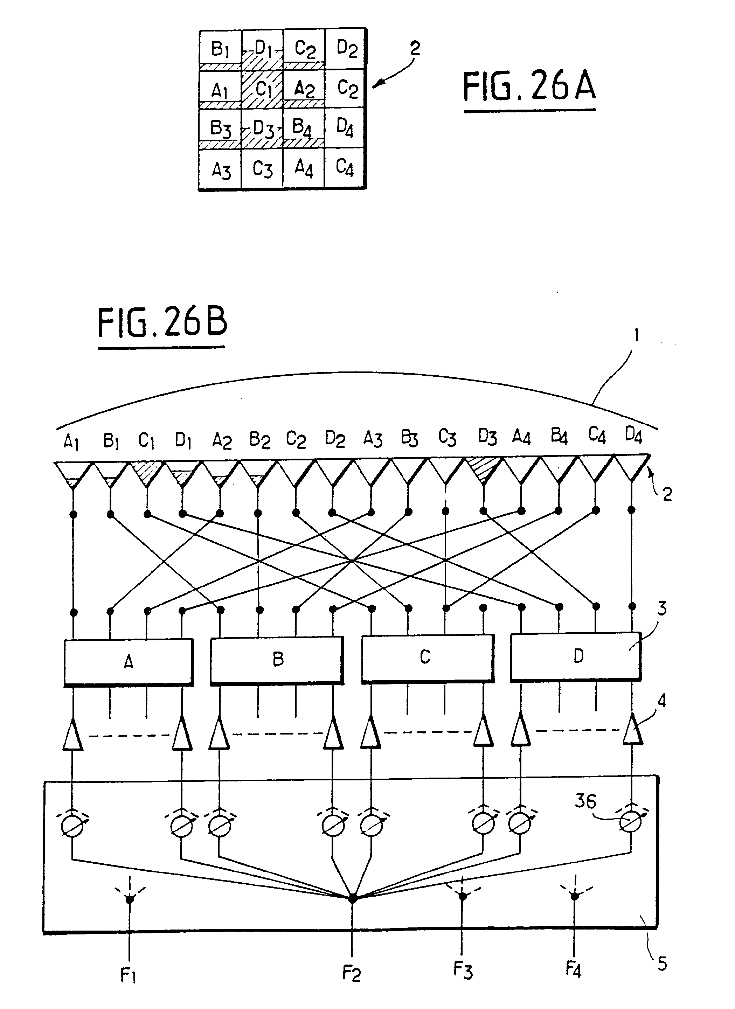

Le principe du mode de réalisation des figures 26A à 26B est le même que dans le cas précédent, mais dans cet exemple neuf sources adjacentes contribuent à un faisceau. La source centrale reçoit deux fois plus de puissance que les quatre sources les plus proches et quatre fois plus de puissance que les quatre autres sources, c'est-à-dire celles situées sur la diagonale du carré (figure 26A). On obtient ainsi une amélioration à la fois sur le plan du rendement et sur celui des lobes secondaires.

Dans cet exemple, quatre faisceaux F1 à F4 sont disponibles et l'on notera que, comme dans le cas précédent, les amplificateurs 4 sont nominalement chargés de façon uniforme.

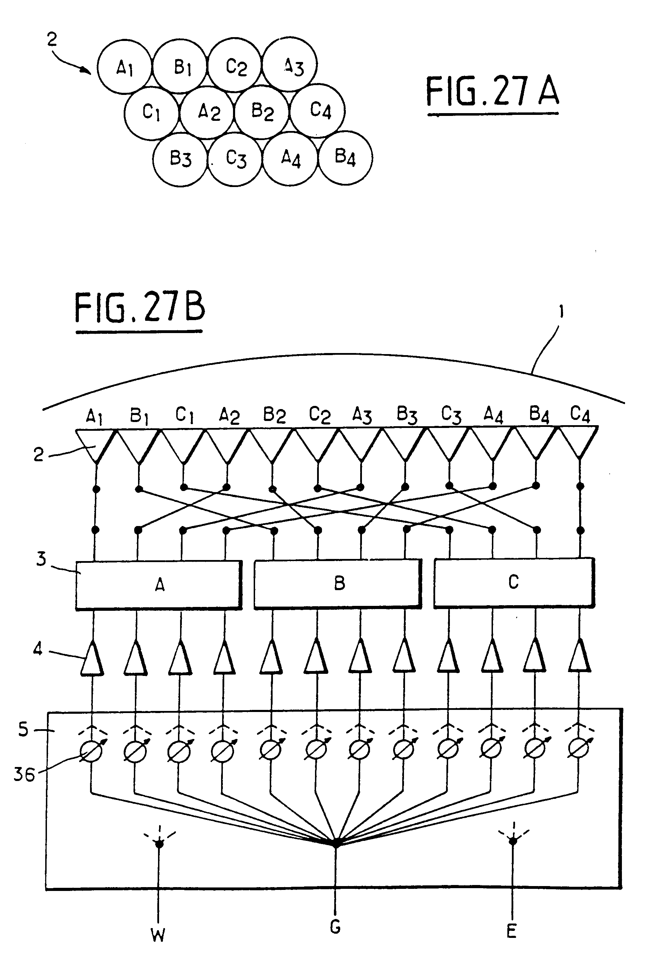

Dans l'exemple des figures 27A et 27B, on cherche, en reliant à un même diviseur plusieurs sources parmi celles qui contribuent à un même faisceau, à optimiser essentiellement la forme de chaque faisceau.

Dans cet exemple, les sources A1, A2, B1, B3, C1 et C4 (figure 27A) contribuent au faisceau Ouest (W), les autres au faisceau Est (E), l'ensemble des sources contribuant au faisceau global (G).

On ajuste les phases dans le réseau formateur de faisceaux (5) au moyen de déphaseurs (36) afin d'obtenir la répartition voulue en sortie des diviseurs de puissance. On notera que, ici encore, tous les amplificateurs 4 sont nominalement au même niveau de puissance.

En ce qui concerne les sources, leurs phases individuelles peuvent être ajustées notamment en choisissant la longueur de leurs câbles d'alimentation, leurs amplitudes étant ajustées par le réglage des déphaseurs 36.

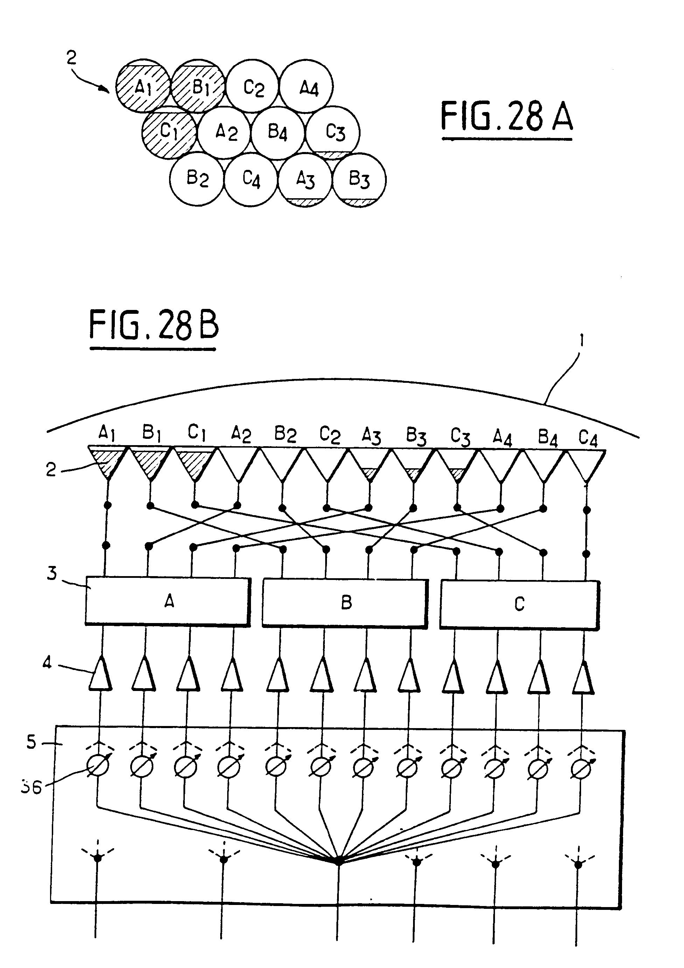

Dans l'exemple des figures 28A et 28B, on cherche essentiellement à réduire les lobes secondaires dans certaines zones en reliant à un même diviseur plusieurs des sources contribuant à un même faisceau.

Ainsi, trois sources contribuent pour l'essentiel à chaque faisceau (par exemple pour le faisceau 1, les sources A1, B1 et C1), mais quelques sources extérieures peuvent être légèrement excitées (ici A3, B3 et C3) pour réduire le rayonnement secondaire dans les zones correspondantes.

Il suffit à cet effet d'ajuster dans le réseau formateur de faisceaux 5 les phases entre l'entrée de faisceau et les sorties, les niveaux de A3, B3 et C3 pouvant ainsi être ajustés indépendamment dans l'exemple de la figure.

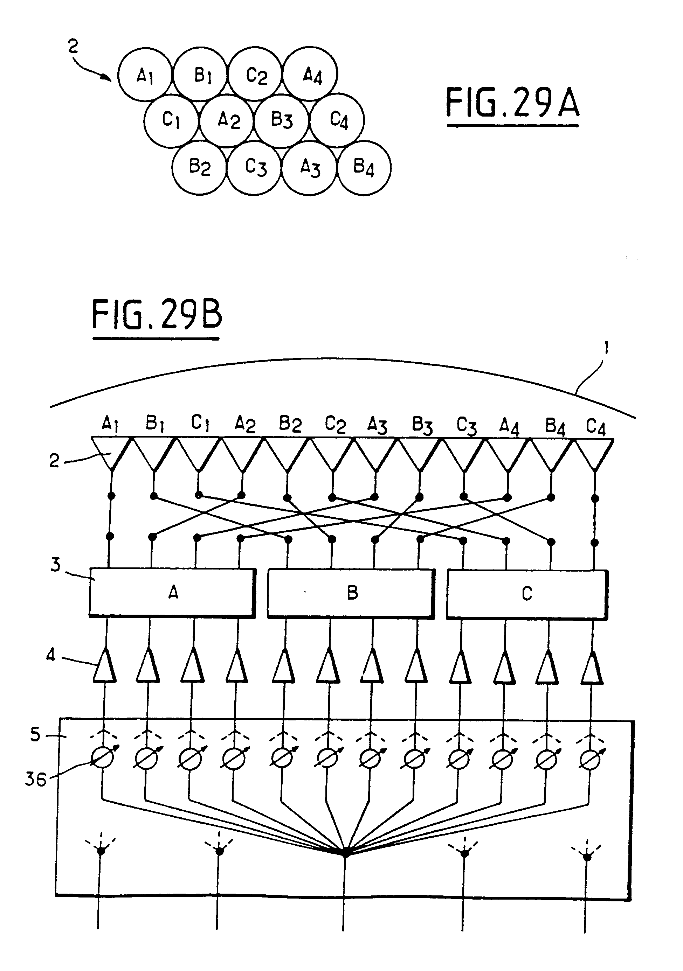

Enfin, sur les figures 29A et 29B, on a illustré un dispositif dans lequel la position et/ou la forme des faisceaux est ajustable par ajustement variable des phases au moyen de déphaseurs, qui sont des déphaseurs variables 36 incorporés au réseau formateur de faisceaux 5.

Ainsi, pour passer du faisceau A1 - B1 - C1 au faisceau B1 - C1 - A2, la puissance de la matrice A est transférée progressivement de la sortie A1 vers la sortie A2 par réglage des phases à l'entrée de la matrice A pour ce faisceau.

Il est également possible de transformer le faisceau A1 - B1 - C1 en un faisceau plus étendu A1 - B1 - C1 - A2 - B2 - C2 en ajustant les phases dans le réseau formateur de faisceaux 5.

Cette technique permet en outre de reconfigurer en même temps plusieurs faisceaux.

## Revendications

1. Une antenne multifaisceau comportant : des moyens formant réflecteur (1) ou lentille; Ne sources primaires (2); et un dispositif d'alimentation coopérant avec ces Ne sources primaires et produisant Nb faisceaux, engendrés chacun à partir d'un sous-groupe de sources primaires dont certaines sont partagées entre faisceaux se recoupant, caractérisé en de que le dispositif d'alimentation comporte :
- un ensemble de Nc diviseurs de puissance multiports hybrides (3), avec chacun un nombre égal d'entrées et de sorties, ce nombre étant une puissance de 2, de 3 ou un produit d'une puissance de 2 par une puissance de 3, et chacun étant à matrice de diffusion orthogonale et unitaire,
l'ensemble des diviseurs (3) présentant dans sa totalité un nombre Na de sorties tel que Na ≧ Ne, ces Na sorties étant reliées aux Ne sources (2) ou à des charges si Na > Ne, de manière que, pour tout faisceau, chaque diviseur (3) active une des sources primaires contribuant à ce faisceau,
- un ensemble de Na modules amplificateurs (4), tel que chaque entrée de chaque diviseur (3) soit reliée à un module (4), chaque module comportant un amplificateur de puissance d'émission et/ou un amplificateur faible bruit de réception, et que tous les amplificateurs opèrent essentiellement au même niveau nominal optimum lorsque la charge en trafic relative des faisceaux varie, et
- un réseau de formation de faisceaux (5), à Nb entrées et Na sorties, dans lequel chaque entrée est reliée à toutes les sorties avec les déphasages d'insertion voulus pour chaque faisceau, les Na sorties étant reliées aux Na modules amplificateurs (4) insérés entre les diviseurs (3) et le réseau de formation de faisceaux (5).

2. Antenne multifaisceau selon la revendication 1, caractérisée en ce que les diviseurs de puissance (3) sont formés de matrices dont certaines au moins sont entre celles d'ordres différents de manière à améliorer, par le choix des ordres, les caractéristiques de rendement, de forme et/ou de lobes secondaires des faisceaux.

3. Antenne multifaisceau selon la revendication 1, caractérisée en ce que, parmi les sources d'un groupe contribuant à un même faisceau, plusieurs sont reliées à un même diviseur de puissance (3), de manière à améliorer les caractéristiques de rendement, de forme et/ou de lobes secondaires des faisceaux par pondération des excitations des sources.

4. Antenne multifaisceau selon la revendication 1, caractérisée en ce que les diviseurs de puissance à matrice (3) sont constitués par des coupleurs de type généralisé, constitués à partir de coupleurs hybrides à 3dB.

5. Antenne multifaisceau selon la revendication 1, caractérisée en ce que les diviseurs de puissance (3) sont constitués par des matrices de type Butler ou similaires, où des déphaseurs fixes choisis sont introduits entre certains coupleurs hyrides à 3dB, de manière à adapter le diviseur aux besoins spécifiques de forme de faisceaux.

6. Antenne multifaisceau selon la revendication 1, caractérisée en ce que le réseau de la formation des faisceaux (5) comporte des déphaseurs (36) variables insérés, pour chaque faisceau contrôlable, entre l'entrée correspondante et les sorties du réseau de formation de faisceaux (5), de manière à contrôler la forme, le contour, les lobes secondaires et le pointage de ce faisceau.

7. Antenne multifaisceau selon la revendication 6, caractérisée en ce que les déphaseurs sont des déphaseurs (36) analogiques ou quantifiés.

8. Antenne multifaisceau selon la revendication 1, caractérisée en ce que le réseau formateur de faisceaux (5) est un réseau numérique.

9. Antenne multifaisceau selon la revendication 1, caractérisée en ce que le réseau formateur de faisceaux (5) est un réseau optique de formation de faisceaux.

10. Antenne multifaisceau selon la revendication 1, caractérisée en ce que le réseau formateur de faisceaux (5) fonctionne à une fréquence intermédiaire et en ce que l'on prévoit des convertisseurs de fréquence branchés à l'entrée des amplificateurs.

11. Antenne multifaisceau selon la revendication 1, caractérisée en ce que le réflecteur (1) est conformé pour améliorer les performances.

12. Antenne multifaisceau selon la revendication 1, caractérisée en ce que le réflecteur (1) est surdimensionné.

13. Antenne multifaisceau selon la revendication 1, caractérisée en ce que lesdits moyens formant réflecteur ou lentille comprennent un système multiréflecteur ou multilentille ou une combinaison de lentilles et de réflecteurs.

14. Antenne multifaisceau selon la revendication 1, caractérisée en ce que la surface sur laquelle se trouvent les sources (2) peut être optimisée ou déplacée autour du foyer.

15. Antenne multifaisceau selon la revendication 1, caractérisée en ce que les longueurs des lignes entre les diviseurs hybrides (3) et les sources sont ajustées pour améliorer les performances, notamment pour un faisceau global utilisant toutes les sources primaires (2).

## Patentansprüche

1. Eine Mehrstrahlrichtantenne bestehend aus: Elementen, die Reflektor (1) oder Linse bilden; Ne Primärstrahlern (2) und einem Speisesystem, das mit diesen Ne Primärstrahlern zusammenwirkt und Nb Richtstrahlen erzeugt, die jeweils von einer Untergruppe von Primärstrahlern erzeugt werden, von denen bestimmte an mehreren sich überlappenden Richtstrahlen teilhaben, dadurch gekennzeichnet, daß sich das Speisesystem zusammensetzt aus:
- einer Gruppe von Nc Vieltor-Hybrid-Leistungsteilern (3) mit jeweils gleich vielen Ein- und Ausgängen, deren Anzahl eine Potenz von 2, eine Potenz von 3 oder das Produkt einer Potenz von 2 und einer Potenz von 3 ist, wobei jeder Leistungsteiler die Eigenschaften einer orthogonalen und unitären Streumatrix hat, die Gruppe der Leistungsteiler (3) insgesamt eine Anzahl von Na Ausgängen aufweist, so daß Na ≧ Ne ist, und diese Na Ausgänge mit den Ne Primärstrahlern (2), oder, wenn Na > Ne ist, mit Lastimpedanzen verbunden sind, derart, daß jeder Leistungsteiler (3) für jeden Richtstrahl einen der Primärstrahler aktiviert, der zu diesem Richtstrahl beiträgt,
- einer Gruppe von Na Verstärkermodulen (4), so, daß jeder Eingang jedes Leistungsteilers (3) mit einem Modul (4) verbunden ist, jedes Modul aus einem Leistungs-Sendeverstärker und/oder einem rauscharmen Empfangsverstärker besteht und alle Verstärker überwiegend mit der gleichen optimalen Nennleistung arbeiten, während sich die relative Auslastung der Richtstrahlen beim Betrieb ändert und
- einem Strahlbildungsnetzwerk (5) mit Nb Ein- und Na Ausgängen, innerhalb dessen jeder Eingang unter den für jeden Richtstrahl erwünschten Einfügungsphasenverschiebungen mit allen Ausgängen verbunden ist, und die Na Ausgänge mit den zwischen Leistungsteilern (3) und Strahlbildungsnetzwerk (5) geschalteten Na Verstärkermodulen (4) verbunden sind.

2. Mehrstrahlrichtantenne nach Anspruch 1, dadurch gekennzeichnet, daß die Leistungsteiler (3) aus Matrizen gebildet sind, von denen zumindest einige unterschiedlicher Ordnung sind, um durch die Wahl der Ordnungen die Leistungs-, die Richt- und/oder die Nebenkeulencharakteristik der Richtstrahlen zu verbessern.

3. Mehrstrahlrichtantenne nach Anspruch 1, dadurch gekennzeichnet, daß unter den Primärstrahlern einer Gruppe, die zu dem selben Richtstrahl beitragen, mehrere mit ein und demselben Leistungsteiler (3) verbunden sind, so, daß die Leistungs-, die Richt- und/oder die Nebenkeulencharakteristik der Richtstrahlen durch Gewichtung der Erregung der Primärstrahler verbessert wird.

4. Mehrstrahlrichtantenne nach Anspruch 1, dadurch gekennzeichnet, daß die Matrix-Leistungsteiler (3) aus verallgemeinerten Kopplertypen auf der Grundlage von 3-dB-Hybridkopplern aufgebaut sind.

5. Mehrstrahlrichtantenne nach Anspruch 1, dadurch gekennzeichnet, daß die Leistungsteiler (3) aus Butler- oder ähnlichen Matrizen aufgebaut sind, bei denen ausgewählte konstante Phasenschieber zwischen bestimmte 3-dB-Hybridkoppler geschaltet werden, um den Leistungsteiler an die spezifischen Anforderungen der Richtcharakteristik des Richtstrahls anzupassen.

6. Mehrstrahlrichtantenne nach Anspruch 1, dadurch gekennzeichnet, daß das Strahlbildungsnetzwerk (5) aus variablen Phasenschiebern (36) besteht, die für jeden steuerbaren Richtstrahl zwischen den entsprechenden Eingang und die Ausgänge des Strahlbildungsnetzwerkes (5) geschaltet werden, um die Richtcharakteristik, die Kontur, die Nebenkeulen und die Ausrichtung dieses Richtstrahls zu steuern.

7. Mehrstrahlrichtantenne nach Anspruch 6, dadurch gekennzeichnet, daß es sich bei den Phasenschiebern (36) um analoge oder um digitale Phasenschieber handelt.

8. Mehrstrahlrichtantenne nach Anspruch 1, dadurch gekennzeichnet, daß das Strahlbildungsnetzwerk (5) ein numerisches Netzwerk ist.

9. Mehrstrahlrichtantenne nach Anspruch 1, dadurch gekennzeichnet, daß das Strahlbildungsnetzwerk (5) ein optisches Strahlbildungsnetzwerk ist.

10. Mehrstrahlrichtantenne nach Anspruch 1, dadurch gekennzeichnet, daß das Strahlbildungsnetzwerk (5) bei einer Zwischenfrequenz arbeitet und daß Frequenzwandler vorgesehen sind, die an den Eingang der Verstärker angeschlossen werden.

11. Mehrstrahlrichtantenne nach Anspruch 1, dadurch gekennzeichnet, daß der Reflektor (1) angepaßt wird, um das Betriebsverhalten zu verbessern.

12. Mehrstrahlrichtantenne nach Anspruch 1, dadurch gekennzeichnet, daß der Reflektor (1) überdimensioniert ist.

13. Mehrstrahlrichtantenne nach Anspruch 1, dadurch gekennzeichnet, daß die genannten Elemente, die den Reflektor oder die Linse bilden, ein Multi-Reflektor- oder ein Multi-Linsensystem oder ein kombiniertes System aus Linsen und Reflektoren umfassen.

14. Mehrstrahlrichtantenne nach Anspruch 1, dadurch gekennzeichnet, daß die Fläche auf der sich die Primärstrahler befinden, optimiert oder in der Umgebung des Brennpunktes verschoben werden kann.

15. Mehrstrahlrichtantenne nach Anspruch 1, dadurch gekennzeichnet, daß die Leitungslängen zwischen den Hybrid-Leistungsteilern (3) und den Primärstrahlern so eingestellt sind, daß das Betriebsverhalten verbessert wird, insbesondere für einen Globalstrahl, der alle Primärstrahler (2) nutzt.

## Claims

1. A multiple beam antenna comprising: reflector (1) or lens forming means; Ne primary sources (2) and a feeding device cooperating with these Ne primary sources and producing Nb beams, each one of which is generated from a subgroup of primary sources, certain of which are divided between beams which intersect each other, characterized in that the feeding device comprises:
- a group of Nc hybrid multiport power dividers (3), each of which has an equal number of inputs and outputs, this number being a power of 2, of 3 or a product of a power of 2 by a power of 3 and each one being at an orthogonal and unitary diffusion matrix, the group of dividers (3) having in its totality a number Na of outputs such that Na ≧ Ne, these Na outputs being connected to the Ne sources (2) or to loads if Na > Ne in such a way that, for each beam, each divider (3) activates one of the primary sources contributing to this beam,
- a group of Na amplifier modules (4) such that each input of each divider (3) is connected to a module (4), each module comprising a transmission power amplifier and/or a low reception noise amplifier and that all the amplifiers operate essentially at the same optimum nominal level when the relative traffic load of the beams varies and
- a beam forming network (5) with Nb inputs and Na ouptuts, in which each input is connected to all the outputs with the insertion phase shifts desired for each beam, the Na outputs being connected to the Na amplifier modules (4) inserted between the dividers (3) and the beam forming network (5).

2. Multiple beam antenna according to Claim 1, characterized in that the power dividers (3) are formed from matrices, certain of which at least are of different orders amongst themselves in such a way as to improve, by the choice of the orders, the characteristics relating to output, shape and/or secondary lobes of the beams.

3. Multiple beam antenna according to Claim 1, characterized in that, amongst the sources of a group contributing to the same beam, several are connected to the same power divider (3) in such a way as to improve the characteristics relating to output, shape and/or secondary lobes of the beams by weighting of the excitations of the sources.

4. Multiple beam antenna according to Claim 1, characterized in that the matrix power dividers (3) are made up of couplers of a generalized type formed from 3dB hybrid couplers.

5. Multiple beam antenna according to Claim 1, characterized in that the power dividers (3) are formed from Butler or similar type matrices where chosen fixed phase shifters are introduced between certain 3dB hybrid couplers in such a way as to adapt the divider to the specific beam shape requirements.

6. Multiple beam antenna according to Claim 1, characterized in that the beam forming network (5) comprises inserted variable phase shifters (36) for each controllable beam between the corresponding input and the outputs of the beam forming network (5) in such a way as to control the shape, the contour, the secondary lobes and the direction of this beam.

7. Multiple beam antenna according to Claim 6, characterized in that the phase shifters are analog or quantified phase shifters (36).

8. Multiple beam antenna according to Claim 1, characterized in that the beam forming network (5) is a digital network.

9. Multiple beam antenna according to Claim 1, characterized in that the beam forming network (5) is an optical beam forming network.

10. Multiple beam antenna according to Claim 1, characterized in that the beam forming network (5) functions at an intermediate frequency and in that frequency converters connected to the input of the amplifiers are provided.

11. Multiple beam antenna according to Claim 1, characterized in that the reflector (1) is formed so as to improve the performance levels.

12. Multiple beam antenna according to Claim 1, characterized in that the reflector (1) is oversized.

13. Multiple beam antenna according to Claim 1, characterized in that the said reflector or lens forming means comprise a multi-reflector or multi-lens system or a combination of lenses and reflectors.

14. Multiple beam antenna according to Claim 1, characterized in that the surface on which the sources (2) are located can be optimized or moved about the focal point.

15. Multiple beam antenna according to Claim 1, characterized in that the lengths of the lines between the hybrid dividers (3) and the sources are adjusted to improve the performance levels, in particular for an all round beam using all the primary sources (2).
